# EUROPEAN PATENT APPLICATION

(11) **EP 1 821 147 A1**
(43) Date of publication of application: **22.08.2007**
(21) Application number: 07290209.1
(22) Date of filing: 19.02.2007
(51) Int. Cl.: G03F 7/039, G03F 7/32

(54) **Resist composition for supercritical development**

(30) Priority: 21.02.2006 JP 2006043459
(71) Applicant: TOKYO OHKA KOGYO CO., LTD., Kawasaki-shi, Kanagawa 211-0012 (JP)
(72) Inventor: Hirosaki, Takako, c/o TOKYO OHKA KOGYO CO., LTD., Kawasaki-shi Kanagawa 211-0012 (JP); Uchida, Ryusuke, c/o TOKYO OHKA KOGYO CO., LTD., Kawasaki-shi Kanagawa 211-0012 (JP); Mimura, Takeyoshi, c/o TOKYO OHKA KOGYO CO., LTD., Kawasaki-shi Kanagawa 211-0012 (JP)
(74) Representative: Touati, Catherine

(57) **Abstract**

In a resist composition for supercritical development process, a development process is carried out by supercritical development process without alkali development process, and includes a base resin which is not removed by said supercritical developer in the presence of acid (A) and an acid generator which generates an acid upon activation by light or electromagnetic waves (B).

## Description

This application is based on and claims the benefit of priority from Japanese Patent Application No. 2006-043459, filed on 21 February 2006, the content of which is incorporated herein by reference.

### BACKGROUND OF THE INVENTION

### Field of the Invention

The present invention relates to a resist composition for supercritical development process. More particularly, the present invention relates to a resist composition which gives the resist pattern having favorable line edge roughness (LER) and line width roughness (LWR) and having high verticality in addition to reducing pattern distortion and pattern collapse by using supercritical development process and which is consequently applicable to ultrafine pattern.

### Related Art

To meet the needs for high integration and miniaturization of semiconductor elements in recent years, use of highly sensitive chemically amplified resist which may achieve high dimensional accuracy and readily provide a high aspect ratio have been investigated for the purpose of forming a fine pattern.

As a composition for such a chemically amplified resist composition, for example, there are known a composition which includes a base resin having solubility in an aqueous alkaline solution increased by the action of an acid, and an acid generator that generates an acid in response to an electromagnetic wave and the like (Patent Document 1, corresponding to US Patent Application No. 2004/0229161 A1).

Additionally, forming of patterns begins with formation of film from the chemically amplified resist composition and then the resulting film is exposed to the light source, thereby generating acid from the acid generator at the exposed region of the film. The photo acid generated reacts with the base resin to eliminate the protective group of the base resin at the exposed region. Successively, the deprotected base resin at the exposed region was selectively removed in the successive development step by dissolving in developer, accordingly the resist pattern is obtained.

In addition, the process wherein the film obtained by coating the photosensitive resin composition is exposed and followed by the development with the supercritical developer consisting of a supercritical fluid is disclosed in Patent Document 2.

(Patent Document 1) Japanese Unexamined Patent Application Publication No. 2004-334107

(Patent Document 2) US Patent Application No. 2005/0227183

### SUMMARY OF THE INVENTION

However, in the development process using an alkali developer as in Patent Document 1, the penetration of the alkali developer into the pattern obtained may cause swelling of the pattern, which may result in the distortion of the pattern in the step for drying the formed pattern and the like. The swelling and the distortion of the pattern will be a serious problem, particularly when a fine pattern is required.

In addition, on drying the pattern after the alkali development process, capillary force may act due to the pressure difference between the liquid left in the pattern and external air, which leads the formed pattern to collapse. Such pattern collapse phenomenon becomes prominent for a pattern having a higher aspect ratio.

The present invention was accomplished in view of the foregoing problems. An object of the present invention is to provide a resist composition for supercritical development process which gives a pattern having high aspect ratio in addition to reducing pattern distortion due to swelling of the pattern and pattern collapse.

In order to solve the aforementioned problems, the present inventors extensively investigated resist compositions optimized for a supercritical development process. Consequently, it was found that the problem can be solved by using a composition including a base resin which is not removed by the supercritical developer in the presence of an acid, and an acid generator which generates an acid upon activation with lights and/or electromagnetic waves. Accordingly, the present invention was accomplished. More specifically, the present invention provides the following.

A resist composition for supercritical development process for forming a resist pattern wherein exposed film is treated with a supercritical developer comprising a supercritical fluid to allow the unexposed region of the exposed resist film to be selectively removed, the resist composition includes a base resin which is not removed by the supercritical developer in the presence of acid (A), and an acid generator which generates an acid upon activation with lights and/or electromagnetic waves (B).

### BRIEF DESCRIPTION OF THE DRAWINGS

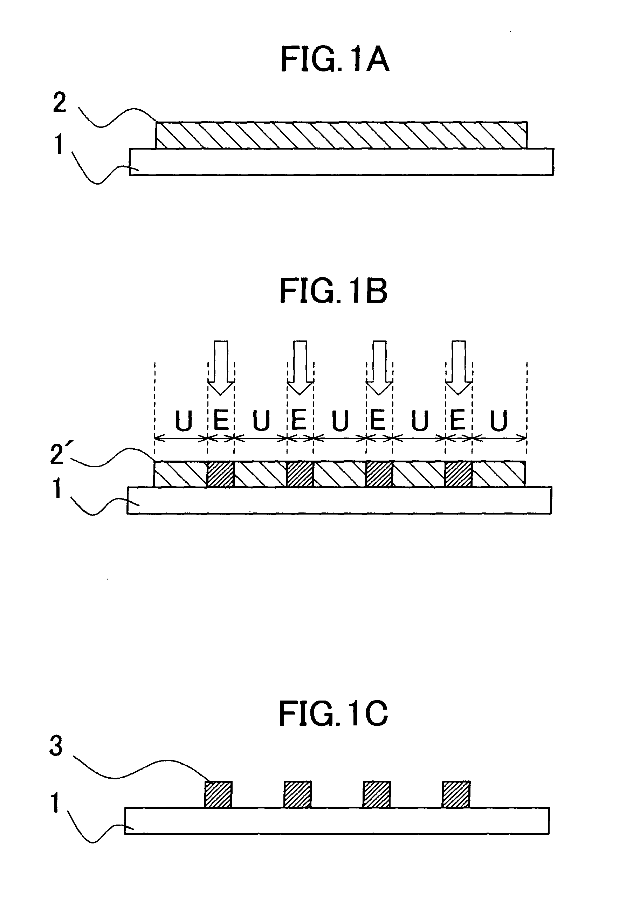

Figs. 1A to 1C show views illustrating steps in a method for pattern formation by lithography.

### DETAILED DESCRIPTION OF THE INVENTION

The resist composition of the present invention gives negative pattern through positive-negative inversion by treating the resist which gives positive pattern in the conventional alkali development with the supercritical development process. In addition, the resist composition of the present invention gives a resist pattern excellent in both Line Edge Roughness (LER) and Line Width Roughness (LWR) and exhibits excellent verticality in addition to reducing pattern distortion and pattern collapse, and consequently it is applicable to ultrafine patterns.

### Resist Composition (Resist Composition for Supercritical Development Process)

Hereinafter, the resist composition of the present invention will be explained. The resist composition of the present invention includes (A) a base resin which is not removed by the supercritical developer in the presence of acid and (B) an acid generator which generates an acid upon activation with light or electromagnetic waves.

### Base Resin (A)

The base resin of the present invention (A) includes a constituent unit (a1) as an indispensable constituent unit and at least some of hydrogen atoms of the hydroxyl groups of the constituent unit (a1) are protected by being substituted by an acid-dissociable group.

### Constituent Unit (a1)

The constituent unit (a1) is represented by the following general formula (I) and at least some of hydrogen atoms of the hydroxyl groups of the constituent unit (a1) are substituted by an acid-dissociable group represented by at least one of the following general formula (II) and/or the following general formula (III). 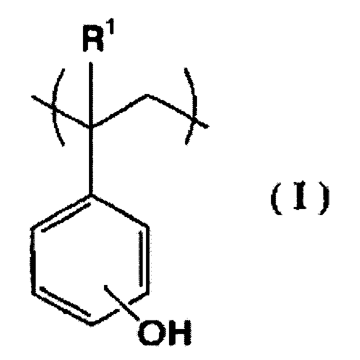 wherein R¹ represents a hydrogen atom or a methyl group. 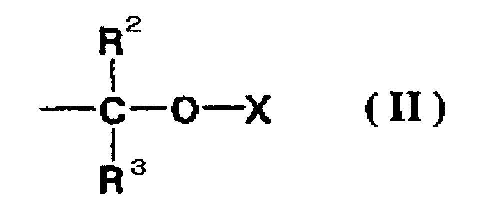 wherein
R² and R³ each independently represent an alkyl group having 1 to 5 carbon atoms or a hydrogen atom, and
X represents any one of the groups selected from the group consisting of an alkyl group having 1 to 5 carbon atoms, an aliphatic polycyclic group, and an aromatic polycyclic hydrocarbon group. 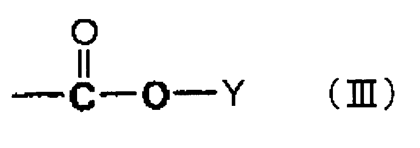 wherein
Y represents any one of the groups selected from the group consisting of an alkyl group having 1 to 5 carbon atoms, an aliphatic polycyclic group, and an aromatic polycyclic hydrocarbon group.

In the constituent unit (a1), R¹ is a hydrogen atom or a methyl group, and preferably a hydrogen atom. When R¹ is a hydrogen atom, protection rate (substitution rate) of the hydroxyl group can be improved and consequently higher contrast can be achieved. In addition, When R¹ is a hydrogen atom, dissolution rate in the supercritical development process can be enhanced.

The position of the hydroxyl group in the constituent unit (a1) may be any of o-, m-, and p-position, however, the p-position is preferred because of its availability and lower commercial price.

Some of the hydrogen atoms of the hydroxyl groups of the constituent unit (a1) must be protected by being substituted by an acid-dissociable group represented by at least one of the aforementioned general formula (II) and the general formula (III).

R² and R³ in the general formula (II) each independently represent an alkyl group having 1 to 5 carbon atoms or a hydrogen atom. The alkyl group having 1 to 5 carbon atoms may be linear or branched, and examples thereof include, e.g., methyl group, ethyl group, propyl group, isopropyl group, n-butyl group, isobutyl group, tert-butyl group, pentyl group, isopentyl group, neopentyl group, and the like. Among these, from the aspect of industry, methyl or ethyl groups are preferred as R², and hydrogen atom is preferred as R¹.

Additionally, at least one of X and Y are any one of the groups selected from the group consisting of an alkyl group having 1 to 5 carbon atoms, an aliphatic polycyclic group, and an aromatic polycyclic hydrocarbon group. Among these, aliphatic polycyclic groups having 10 to 16 carbon atoms and aromatic polycyclic hydrocarbon groups having 10 to 16 carbon atoms are preferred.

As the alkyl group having 1 to 5 carbon atoms, any one among the substituents similar to the aforementioned R² and R³ can be selected.

As the aliphatic polycyclic group having 10 to 16 carbon atoms which can preferably be used, a properly selected one among many groups proposed for conventional ArF resist including the groups wherein one hydrogen atom is removed from, e.g., bicycloalkanes, tricycloalkanes, tetracycloalkanes, and the like can be used. Specific examples include the groups wherein one hydrogen atom is removed from polycycloalkanes such as adamantane, norbornane, isobornane, tricyclodecane, and tetracyclodecane. Among these, adamantyl group, norbornyl group, and tetracyclododecanyl group are preferred industrially, and adamantyl group is particularly preferred.

Examples of the aromatic polycyclic hydrocarbon group having 10 to 16 carbon atoms include, e.g., the groups wherein one hydrogen atom is removed from naphthalene, anthracene, phenanthrene, pyrene, and the like. Specific examples include 1-naphthyl group, 2-naphthyl group, 1-anthracenyl group, 2-anthracenyl group, 1-phenanthryl group, 2-phenanthryl group, 3-phenanthryl group, 1-pyrenyl group, and the like. Among these, 2-naphthyl group is preferred industrially.

As mentioned above, by using adamantyl group as at least one of X and Y, favorable line edge roughness of the pattern and rectangularity of the cross-sectional shape may be provided. In addition, the use of naphthyl group, an aromatic polycyclic hydrocarbon group as the terminal of the acid-dissociable group improves the sensitivity and promotes throughput, and thereby productivity is improved.

Examples of the preferable acid-dissociable group in constituent unit (a1) include the groups represented by the following general formula (II-a), and the general formula (II-b).

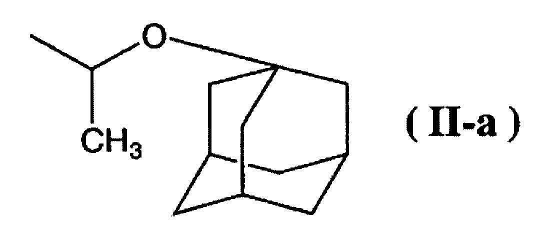

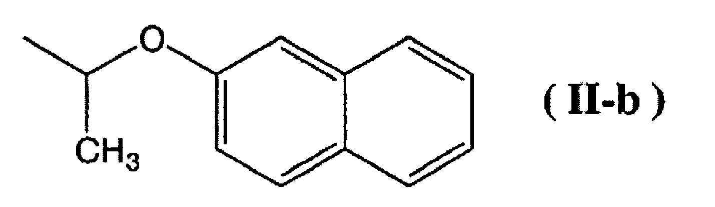

The base resin (A) includes the constituent unit (a1) as an indispensable constituent unit and the polymer thereof has a bulky structure, which provides the resist film obtained from the resist composition with higher resistance against the etching. Therefore, the resist film may be thinned and the pattern with higher resolution may be achieved.

### Constituent Unit (a2)

In the resist composition of the present invention, the polymer included in the base resin (A) is preferably a copolymer further including a constituent unit (a2) in addition to the aforementioned constituent unit (a1). The constituent unit (a2) is represented by the following general formula (IV). When the constituent (a2) is included, the solubility can be controlled by the amount thereof, and also the line edge roughness (LER) can be reduced and favorable isolate lines can be obtained. 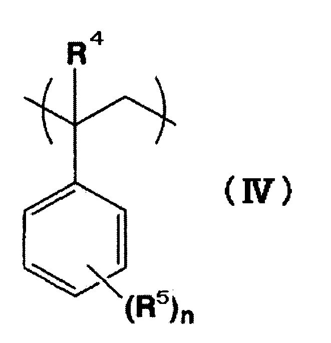 wherein
- R⁴: represents a hydrogen atom or a methyl group,
- R⁵: represents an alkyl group having 1 to 5 carbon atoms, and
- n: represents an integer of 0 or 1 to 3.
- R⁵: of the aforementioned general formula (IV) represents an alkyl group having 1 to 5 carbon atoms and may be linear or branched. Examples thereof include, e.g., methyl group, ethyl group, propyl group, isopropyl group, n-butyl group, isobutyl group, tert-butyl group, pentyl group, isopentyl group, neopentyl group, and the like. Among these, from the aspect of industry, methyl or ethyl groups are preferred.

The letter n of the aforementioned general formula (IV) represents an integer of 0 or 1 to 3. Among these, 0 and 1 are preferred and 0 is particularly preferred from the aspect of industry.

In addition, when n is 1 to 3, the substitution position of R⁵ may be any of o-, m-, and p-position. Moreover, when n is 2 or 3, any combination of the substitution positions may be adopted.

When the constituent unit (a2) is included in the copolymer in the present invention, the amount thereof is preferably 0.5 mol % to 25 mol %, and more preferably 3 mol % to 20 mol % per total amount of the constituents constituting the copolymer. When the amount of the constituent unit (a2) is greater than 25 mol %, line edge roughness may be increased or there may be difficulty in obtaining preferable isolated lines.

As the base resin (A) used for the resist composition, any one of the aforementioned polymers may be used alone, or in combination of two or more. When the aforementioned polymers are used in combination of two or more, any combinations may be selected from the polymer including the constituent unit (a1) in which at least a part of the hydroxyl groups of the constituent unit (a1) are substituted by the acid-dissociable groups, or the copolymer including the constituent units (a1) and (a2) in which at least a part of the hydroxyl groups of the constituent unit (a1) are substituted by the acid-dissociable groups.

Among these, the use of the mixture of the polymer including the constituent unit (a1) in which at least a part of the hydroxyl groups of the constituent unit (a1) are substituted by the acid-dissociable groups, and the copolymer including the constituent units (a1) and (a2) in which at least some of the hydroxyl groups of the constituent unit (a1) substituted by the acid-dissociable groups, is preferred. The use of such a mixture as the base resin (A) gives the resist pattern having favorable rectangularity of the cross-sectional shape and excellent isolated lines.

The mass average molecular weight of the polymers before substituted by the aforementioned acid-dissociable groups is preferably 2000 to 30000, and more preferably 5000 to 20000 (equivalent to polystyrene). By defining the mass average molecular weight to be 30000 or less, the solubility in the solvent used to produce the resist composition can be improved, whereas, by defining the mass average molecular weight to be 2000 or more, favorable shape of the resist pattern can be achieved.

The small dispersity index (the value obtained by dividing the mass average molecular weight by number average molecular weight) of the polymer before substituted by the aforementioned acid-dissociable groups in the base resin (A) and monodispersity are preferred because of the excellent resolution. In particular, the dispersity index of 2.0 or less is preferred, and 1.5 or less is more preferred.

In the resist composition of the present invention, the content of the constituent unit (a1) wherein the hydroxyl group is substituted by the aforementioned acid-dissociable group is preferably 5 mol % to 35 mol % per total amount of the constituent unit which constitutes the base resin (A).

When the polymer does not include the constituent unit (a2), the amount of the constituent substituted by the aforementioned acid-dissociable group is preferably 5 mol % to 35 mol %, and more preferably 20 mol % to 30 mol % per total amount of the constituent unit.

When the polymer includes the constituent unit (a2), the amount of the constituent substituted by the aforementioned acid-dissociable group is preferably 5 mol % to 35 mol %, and more preferably 10 mol % to 20 mol % per total amount of the constituent unit.

By defining the content of the constituent substituted by the aforementioned acid-dissociable group to be not less than the lower limit value, favorable contrast can be achieved, whereas by defining the content to be not more than the upper limit value, the effect of preventing defects can be achieved.

The method for preparing the base resin (A) is not particularly limited. Examples thereof include the method wherein the monomer corresponding to the constituent unit (a1) wherein hydroxyl group is not substituted is polymerized, and then at least a part of the hydroxyl groups are protected by substituting with the acid-dissociable group using the method well known in the art. Alternatively, the base resin (A) can also be prepared by the method wherein the monomer corresponding to the constituent unit (a1) with hydroxyl group previously substituted with the acid-dissociable group is polymerized in the usual manner and then at least part of the hydroxyl groups substituted by the acid-dissociable group of the resultant polymer are converted to hydroxyl groups by hydrolysis.

The content of the base resin (A) in the resist composition may be determined depending on the thickness of the film to be formed. In general, it is used so that the solid concentration falls within the range of 5% by mass to 25% by mass, and more preferably 7% by mass to 20% by mass.

### Acid generator (B)

As the acid generator (B), a properly selected one from among known acid generator in the conventional chemically amplified resist can be used. Examples of the acid generator (B) include, e.g., onium salt based acid generators such as iodonium salts and sulfonium salts, oximesulfonate based acid generators, diazomethane based acid generators such as bisalkyl or bisaryl sulfonyl diazomethanes, poly(bissulfonyl)diazomethanes and diazomethanenitrobenzyl sulfonates, iminosulfonate based acid generators, disulfone based acid generators, and the like. Also, in the present invention, the acid generator (B) may be used alone, or in combination of two or more.

The amount of compounding the acid generator (B) may be from 5 parts by mass to 30 parts by mass, preferably from 7 parts by mass to 15 parts by mass per 100 parts by mass of the base resin (A). By defining the amount of the acid generator (B) to be 5 parts by mass or greater, which ensures the generation of the acid in the exposure process, the base resin (A) which constitutes the composition is adequately decomposed and the pattern formation is sufficiently executed, while by defining the amount to be 30 parts by mass or less, uniform solutions may be obtained, thereby improving the storage stability.

Specific examples of the onium salt based acid generator include trifluoromethanesulfonate or nonafluorobutanesulfonate of diphenyliodonium, trifluoromethanesulfonate or nonafluorobutanesulfonate of bis(4-tert-butylphenyl)iodonium, trifluoromethanesulfonate, heptafluoropropanesulfonate or nonafluorobutanesulfonate of triphenyl sulfonium, trifluoromethanefulfonate, heptafluoropropanesulfonate or nonafluorobutanesulfonate of tri(4-methylphenyl)sulfonium, trifluoromethanesulfonate, heptafluoropropanesulfonate or nonafluorobutanesulfonate of (4-methylphenyl)diphenylsulfonium, trifluoromethanesulfonate, heptafluoropropanesulfonate or nonafluorobutanesulfonate of (4-methoxyphenyl)diphenylsulfonium, trifluoromethanesulfonate, heptafluoropropanesulfonate or nonafluorobutanesulfonate of dimethyl(4-hydroxynaphthyl)sulfonium, trifluoromethanesulfonate, heptafluoropropanesulfonate or nonafluorobutanesulfonate of monophenyldimethylsulfonate, and the like. Among these, onium salts having a fluorinated alkylsulfonate ion as an anion can be preferably used.

Specific examples of the oximesulfonate based acid generators include α-(methylsulfonyloxyimino)-phenylacetonitrile, α-(methylsulfonyloxyimino)-p-methoxyphenylacetonitrile, α-(trifluoromethylsulfonyloxyimino)-phenylacetonitrile, α-(trifluoromethylsulfonyloxyimino)-p-methoxyphenylacetonitrile, α-(ethylsulfonyloxyimino)-p-methoxyphenylacetonitrile, α-(propylsulfonyloxyimino)-p-methylphenylacetonitrile, α-(methylsulfonyloxyimino)-p-bromophenylacetonitrile, bis-O-(n-butylsulfonyl)-α-dimethylglyoxime, and the like. Among these, α-(methylsulfonyloxyimino)-p-methoxyphenylacetonitrile, bis-O-(n-butylsulfonyl)-a-dimethylglyoxime can be preferably used.

Specific examples of the diazomethane based acid generator include bisalkylsulfonyldiazomethane having a linear or branched alkyl group having 1 to 4 carbon atoms such as bis(n-propylsulfonyl)diazomethane, bis(isopropylsulfonyl)diazomethane, bis(n-butylsulfonyl)diazomethane, and bis(tert-butylsulfonyl)diazomethane;
biscycloalkylsulfonyldiazomethane having a cyclic alkyl group having 5 to 6 carbon atoms such as bis(cyclopentylsulfonyl)diazomethane, and bis(cyclohexylsulfonyl)diazomethane;
bisarylsulfonyldiazomethane having an aryl group such as bis(p-toluenesulfonyl)diazomethane, and bis(2,4-dimethylphenylsulfonyl)diazomethane; and the like.

Moreover, examples of the poly(bissulfonyl)diazomethane include, e.g., 1,3-bis(phenylsulfonyldiazomethylsulfonyl)propane (when A is 3), 1,4-bis(phenylsulfonyldiazomethylsulfonyl)butane (when A is 4), 1,6-bis(phenylsulfonyldiazomethylsulfonyl)hexane (when A is 6), 1,10-bis(phenylsulfonyldiazomethylsulfonyl)decane (when A is 10), 1,2-bis(cyclohexylsulfonyldiazomethylsulfonyl)ethane (when B is 2), 1,3-bis(cyclohexylsulfonyldiazomethylsulfonyl)propane (when B is 3), 1,6-bis(cyclohexylsulfonyldiazomethylsulfonyl)hexane (when B is 6), 1,10-bis(cyclohexylsulfonyldiazomethylsulfonyl)decane (when B is 10), and the like having a structure represented by the following general formula (V):

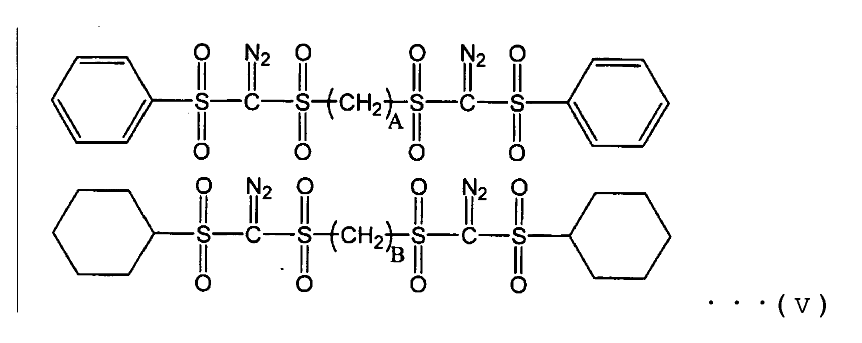

In the present invention, use of the onium salt as the acid generator (B) is preferred in terms of excellent width in the depth of focus and exposure margin. Also, use of diazomethane is preferred because circularity of the resist hole pattern is improved, and standing waves of the cross-sectional pattern is suppressed.

Also, in the present invention, to include the onium salt based acid generator having perfluoroalkylsulfonate having 3 or 4 carbon atoms as an anion (hereinafter, may be abbreviated to C3-4 onium salt) as the acid generator (B) is preferred because masking linearity is improved, and the pattern can be strictly reproduced with the mask even though the pattern involves a variety of sizes, and because one that is excellent in the proximity effect, DOF, exposure margin and the like can be obtained. The alkyl group of the perfluoroalkylsulfonate may be linear or branched, but a linear one is preferred.

When the C3-4 onium salt is compounded as the acid generator (B), the amount of the C3-4 onium salt per total amount of the acid generator (B) is preferably 50% to 100% by mass.

Furthermore, when the C3-4 onium salt is compounded as the acid generator (B), it is preferred that the onium salt based acid generator having perfluoroalkylsulfonate having one carbon atom (hereinafter, thus may be abbreviated to C1 onium salt) be further used in combination.

Moreover, in light of the advantages of the present invention, use of a sulfonium salt among the onium salt is desired.

In addition, a triphenylsulfonium salt is preferably used among the sulfonium salts. When the triphenylsulfonium salt is compounded, the amount thereof may be preferably 30 to 100 mol %, and more preferably 50 to 100 mol % per total amount of the acid generator (B).

In particular, mixing the onium salt and diazomethane is preferred because the circularity of the resist hole pattern can be improved without deteriorating the width in the depth of focus and exposure margin, and the standing waves of the cross-sectional pattern can be suppressed. When this mixture is used, the content of the onium salt in the mixture is preferably 20 to 90 mol %, and more preferably 30 to 70 mol %.

Moreover, among the triphenylsulfonium salts, triphenylsulfonium salts having the perfluoroalkylsulfonate ion as an anion represented by the following general formula (VI) are particularly preferably used because high sensitivity can be achieved: 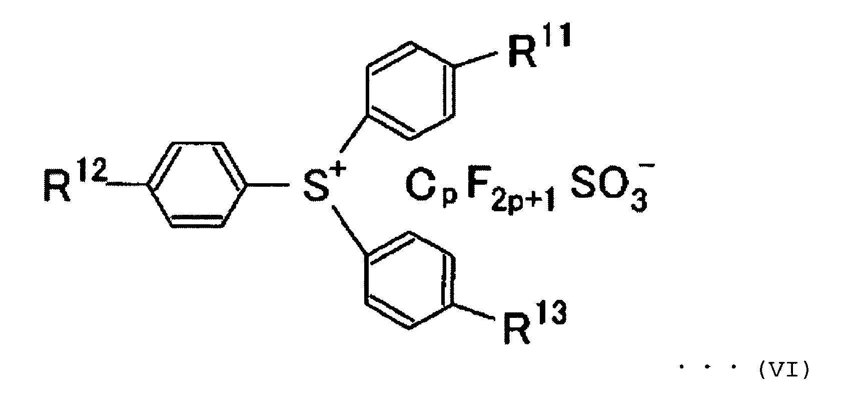 wherein
R¹¹, R¹², and R¹³ each independently represent a hydrogen atom, a lower alkyl group having 1 to 8, preferably 1 to 4 carbon atoms, or a halogen atom such as chlorine, fluorine, or bromine,
p represents an integer of 1 to 12, preferably 1 to 8, and more preferably 1 to 4.

### Other Components

The resist composition of the present invention may further include optional components in addition to the base resin (A), and the acid generator (B). Examples of the optional component include, e.g., a basic compound (C), an organic acid (D), other additives and the like.

### Basic Compound (C)

The resist composition of the present invention preferably includes the basic compound (C) which captures the acid generated from the acid generator (B), for the purpose of improving the shape of resist pattern, storage time dependent stability.

The amount of compounding the basic compound (C) may be preferably from 0.1 part by mass to 20 parts by mass, more preferably from 0.3 part by mass to 2 parts by mass per 100 parts by mass of the base resin (A). Defining the amount of compounding the basic compound (C) to be from 0.1 part by mass to 20 parts by mass of the basic compound (C) can prevent the acid generated in the exposure process from diffusing to the unexposed region and suppress the damage and disruption of the pattern.

The basic compound (C) optionally used in the present invention is not particularly limited and a properly selected one among known basic compounds can be used. In the present invention, examples include a nitrogen-containing organic compound and among these, aliphatic amine can be preferably used. Moreover, "higher" alkyl or hydroxyalkyl group having 7 to 15 carbon atoms have lipophilicity. Therefore, the aliphatic amine having such groups have improved dispersibility in the composition and can be distributed uniformly in the resist pattern formed. Here, "aliphatic amine" refers to as alkyl- or alkylalcoholamines.

Specific examples of aliphatic amines include, e.g., monoalkylamine such as n-hexylamine, n-heptylamine, n-octylamine, n-nonylamine, and n-decylamine; dialkylamine such as diethylamine, di-n-propylamine, di-n-heptylamine, di-n-octylamine, and dicyclohexylamine; trialkylamine such as trimethylamine, triethylamine, tri-n-propylamine, tri-n-butylamine, tri-n-hexylamine, tri-n-pentylamine, tri-n-heptylamine, tri-n-octylamine, tri-n-nonylamine, tri-n-decanylamine, and tri-n-dodecylamine; alkylalcoholaminde such as diethanolamine, triethanolamine, diisopropanolamine, triisopropanolamine, di-n-octanolamine, and tri-n-octanolamine, and the like. Among these, alkylalcoholamine or trialkylamine are preferred and trialkylamine is most preferred. Particularly, secondary aliphatic amine or tertiary aliphatic amine having alkyl or alkylalcohol groups having 7 to 15 carbon atoms and the like can be preferably used. In particular, tri-n-octylamine is most preferred among the trialkylamines.

When the basic compound (C) is used, it may be used alone or in combination of two or more.

### Organic Acid (D)

The organic acid (D) may be included as an optional component of the resist composition of the present invention for the purpose of preventing deterioration of sensitivity resulting from compounding the basic compound (C), and improving the shape of resist pattern, storage time dependent stability and the like. The organic acid (D) which may be used is not particularly limited, an organic carboxylic acid, or an oxo acid of phosphorous or a derivative thereof may be examplified. The organic acid (D) may be used alone or in combination of two or more.

The content of the organic acid (D) when compounded may fall within the range of preferably from 0.1 part by mass to 20 parts by mass, more preferably from 0.3 part by mass to 3 parts by mass per 100 parts by mass of the base resin (A). Compounding from 0.1 part by mass to 20 parts by mass of the organic acid (D) can suppress the deterioration of sensitivity resulting from compounding the basic compound (C) and dependence on the substrate, and improve the shape of resist pattern, storage time dependent stability and the like.

Examples of the organic carboxylic acid which can be suitably used include, e.g., malonic acid, citric acid, malic acid, succinic acid, benzoic acid, salicylic acid, and the like.

Examples of oxo acid of phosphorous or derivatives thereof include phosphoric acid or derivatives such as esters thereof such as, e.g., phosphoric acid, phosphoric acid di-n-butyl ester, and phosphoric acid diphenyl ester; phosphonic acid and derivatives such as esters thereof such as, e.g., phosphonic acid, phosphonic acid dimethyl ester, phosphonic acid di-n-butyl ester, phenylphosphonic acid, phosphonic acid diphenyl ester, and phosphonic acid dibenzyl ester; phosphinic acid and derivatives such as esters thereof such as, e.g., phosphinic acid, and diphenylphosphinic acid. Among these, phosphonic acid is particularly preferred.

### Other Additives

The resist composition of the present invention may further include therein an additive if desired that is miscible with the composition, for example, an additional resin for improving the performances of the resulting resist film, a surface active agent for improving the coating properties, a dissolution inhibitor, a plasticizer, a stabilizer, a colorant, an antihalation agent, and the like.

### Surface Active Agent

When a surface active agent is compounded, the coating properties of the resultant composition are improved, and the flatness of the resultant film is also improved. Examples of such a surface active agent include, e.g., fluorinated surface active agent such as BM-1000 (manufactured by BM Chemie Co., Ltd.), Megaface F142D, F172, F173, and F183 (manufactured by Dainippon Ink and Chemicals, Ltd.), Fluorad FC-135, FC-170C, Fluorad FC-430, and FC-431 (manufactured by Sumitomo 3M Limited), Surflon S-112, S-113, S-131, S-141, and S-145 (manufactured by Asahi Glass Co., Ltd.), SH-28PA, SH-190, SH-193, SZ-6032, SF-8428, DC-57, and DC-190 (manufactured by Dow Corning Toray Silicone Co., Ltd.), and the like. The ratio of the surface active agent, when compounded, is usually not greater than 5 parts by mass, preferably from 0.01 part by mass to 2 parts by mass per 100 parts by mass of solid content other than the surface active agent.

### Organic Solvent

The resist composition of the present invention is produced by dissolving the base resin (A), the acid generator (B), and the aforementioned optional component if desired preferably in an organic solvent.

The organic solvent which may be used in the resist composition of the present invention may be one which dissolves each component used to give a uniform solution. According to the present invention, a known properly chosen organic solvent which has been conventionally used as the solvent of the chemically amplified resist can be used. These organic solvents may be used alone or as a mixed solvent of two or more thereof.

The amount of the solvent used is not particularly limited, but may be determined properly depending on the coating film thickness at a concentration capable of being coated on the workpiece film. In general, it is used so that the solid content of the resist composition falls within the range of 2 % by mass to 20 % by mass, and preferably 5 % by mass to 15 % by mass.

Examples of the organic solvent include, e.g., lactones such as γ-butyrolactone; ketones such as acetone, methylethylketone, cyclohexanone, methylisoamylketone, and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or monomethyl ether, monoethyl ether, monopropyl ether, monobutyl ether, or monophenyl ether of dipropylene glycol monoacetate; cyclic ethers such as dioxane; esters such as methyl lactate, ethyl lactate (EL), methyl acetate, ethyl acetate, butyl acetate, methyl pyruvate, ethyl pyruvate, methyl methoxypropionate, and ethyl ethoxypropionate, and the like.

According to the present invention, use of a mixed solvent prepared by mixing propylene glycol monomethyl ether acetate (PGMEA) and the polar solvent is preferred as the organic solvent. The compounding ratio (mass ratio) may be properly determined taking into account compatibility of PGMEA and the polar solvent, but falls within the range of preferably 1:9 to 9:1, and more preferably 2:8 to 8:2.

Furthermore, according to the present invention, a mixed solvent including propylene glycol monomethyl ether (PGME) and a solvent having a higher boiling point than PGME may be preferably used. Accordingly, the shape of the resist pattern such as line edge roughness, line width roughness (nonuniformity of horizontal width of the line) and the like can be improved. In addition, the width in the depth of focus (DOF) at the contact hole can be increased simultaneously.

As the solvent having higher boiling point than PGME, for example, one having a boiling point of higher than 120°C, which is the boiling point of PGME, preferably one having a higher boiling point by 20°C or greater, more preferably one having a higher boiling point by 25°C or greater may be used among the above-described solvents. Additionally, the upper limit of the boiling point is not particularly limited, but it is preferably approximately 200°C or lower. Examples of such a solvent include, e.g., propylene glycol monomethyl ether acetate (boiling point: 146°C), EL (boiling point: 155°C), γ-butyrolactone (boiling point: 204°C), and the like. The amount of PGME included in the mixed solvent is preferably from 10% by mass to 60% by mass, and more preferably from 20% by mass to 40% by mass. When the amount of PGME included in the mixed solvent falls within this range, a composition that is superior in the aforementioned effects can be obtained.

### Pattern Formation by Lithography

Figs 1A to 1C show process drawings illustrating steps for formation of patterned resist according to the method for forming a pattern described in Patent Document 2. In this embodiment, a coating step (Fig. 1A), a first baking step (not shown in the Figure), an exposure step (Fig. 1B), a second baking step (not shown in the Figure), and a supercritical developing step (Fig. 1C) are involved. Hereinafter, each step will be explained.

### Coating Step

Fig. 1A shows a drawing illustrating the coating step in the method for forming a pattern according to an embodiment of the present invention. In the coating step, the resist composition is coated on a substrate 1, thereby obtaining a coated film 2 of the resist composition. Examples of the method for coating include, e.g., a spray coating method, a roll coating method, a spin-coating method, and the like.

The material of the substrate which may be used in the present invention is not particularly limited. It can be properly selected for the following application of the pattern. In the present invention, examples of the material include silicon wafers and the like. In addition, an organic or inorganic antireflection film may be provided between the substrate and the coated film 2.

### First Baking Step

In the first baking step, the coated film 2 formed on the substrate 1 in the coating step is baked or semi-baked to form a cured film.

The conditions of the baking or semi-baking are not particularly limited. For example, it may be the heating under the condition of the temperature of 80°C to 150°C for a time period of 40 seconds to 120 seconds, and particularly preferably, under the condition of the temperature of 90°C to 130°C for a time period of 60 seconds to 90 seconds.

### Exposure Step

Fig. 1B shows a view illustrating the exposure step in the method for pattern formation according to an embodiment of the present invention. In the exposure step, the cured film which was obtained by carrying out the baking or semi-baking in the first baking step is exposed (shown in the Figure by an arrow) at least in part to give an exposed film 2' having an exposed region E.

Because the resist composition has the nature of being insoluble in response to the exposure in the below-mentioned exposure process, difference in solubility in the supercritical developer occurs between the exposed region E (insoluble in the developer) and unexposed region U (soluble in the developer). Using the difference in solubility, the unexposed region U can be selectively dissolved in the following supercritical development step.

### Method for Exposure

The method for exposure which may be used in the exposure step of the present invention is not particularly limited as long as at least one of light and electromagnetic waves can be applied to the necessary region of the cured film obtained from the coated film of the resist composition. Examples include, e.g., exposure to an irradiation such as far-ultravaiolet light via a photomask, drawing by an electron beam, and the like.

### Conditions of the Exposure

The conditions of the exposure in the exposure step are not particularly limited. The exposure region, the exposure time period and the like necessary to obtain the desired pattern can be properly selected depending on the method used in the exposure.

### Wavelength of Irradiation

The wavelength of the electron beam and other irradiation such as far-ultraviolet light used for the exposure step is not particularly limited. For example, an ArF excimer laser, KrF excimer laser, F₂ laser, EUV (extreme ultraviolet light), VUV (vacuum ultraviolet light), X rays, soft X rays, and the like may be used.

By using the resist composition of the present invention, distortion of the pattern and pattern collapse are suppressed compared with the conventional ones, and the resist pattern exhibiting favorable line edge roughness (LER) and high verticality can be obtained.

### Second Baking Step

In the second baking step, the cured film with the exposure region E at least in part is further baked. In the method of the present invention, the second baking step is an optional step.

The baking conditions of the second baking step are not particularly limited. For example, it may be the heating under the condition of the temperature of 80°C to 150°C for a time period of 40 seconds to 120 seconds, and particularly preferably, under the condition of the temperature of 90°C to 130°C for a time period of 60 seconds to 90 seconds.

### Supercritical Development Step

Fig. 1C shows a view illustrating the supercritical development step in the method for pattern formation according to Patent Document 2. In the supercritical development process, a particular region of the exposed film 2' subjected to the exposure step and to the second baking step as needed is selectively dissolved to remove by a supercritical developer consisting of a supercritical fluid.

The resist composition acts as a positive resist in the conventional alkali development process (in this case, usually the exposed region E is soluble in the developer); however, when it is applied to the supercritical development process, the exposed region E becomes insoluble and the unexposed region U is dissolved in the developer as a result of negative-positive inversion, and thereby the negative pattern is obtained.

For the purpose of the present invention, "supercritical fluid" refers to the state in which the fluid is compressed to high density, and in extreme cases to the density of liquid or more, under a pressure substantially higher than atmospheric pressure. Increasing the density of fluid in this way, while the microscopic structure thereof becomes closer to that in the liquid state, unique properties such as extremely low kinetic viscosity than usual liquid and remarkably high diffusion coefficient will appear.

Therefore, in the supercritical fluid in the supercritical development process, a large number of molecules exist in the fluid and move vigorously because molecules are compressed to the high density comparable to or higher than that of liquid. Hence, it easily penetrates in the individual molecular level even in the case in which a usual liquid is not capable of penetrating and dissolves the base material resin more precisely. Consequently, the process gives the pattern having favorable line edge roughness (LER) and line width roughness (LWR) and having excellent verticality and is applicable to the ultra fine pattern.

Moreover, in the supercritical development process of the present invention, a negative-positive inverted pattern of that obtained in the conventional development process using alkali developer. In other words, the resist composition, which gives a positive image in the conventional alkali development process, gives negative image in the supercritical development process.

### Supercritical Developer

The supercritical developer used for the supercritical development step of the present invention includes carbon dioxide and quarternary ammonium salts. The supercritical developer which can be used is disclosed in Patent Document 2. Carbon dioxide has low critical points (7.38 MPa, 31°C) and is chemically stable. Therefore, the fluid including carbon dioxide is easily made supercritical and the resultant fluid is stable.

The quaternary ammonium salts useful in the present invention, such as the quaternary ammonium chloride, is soluble in dense carbon dioxide (liquid or supercritical) at pressures between 500 psig and 10000 psig and temperatures between 0°C and 100°C. Most preferred are salts soluble at pressures between 800 psig and 5000 psig at temperatures between 10°C and 60°C.

The positive ion, represented by the formula R¹R²R³R⁴N⁺ preferably contains at least one organic group that is considered CO₂-philic. It is preferable that at least one of R¹ to R⁴ is R^{f}, and more preferable is that two or three of R¹ to R⁴ are R^{f}. In addition, it is preferable that at least one of R¹ to R⁴ is a group having a lower affinity to CO₂.

CO₂-philic groups can be partially or wholly fluorinated, or can consist of siloxane-based or siloxane-containing substituents. These "R_{f}" group can be aliphatic or aromatic in nature or be combinations of both moieties.

Ideally, when the CO₂-philic group R _{f} contains fluorine, the group is attached to the nitrogen center through a non-fluorinated linking group (e.g., R_{f}- is a group of the formula RₐR_{b}-, where Rₐ is a fluorine-containing group and R_{b} is a non-halogenated or non-fluorinated linking group). This is to minimize the inductive effect of fluorinated groups (a very electronegative atom) on the nitrogen atoms.

The prototypical CO₂-philic group R_{f}- is represented by the formula RₐR_{b}-, where Rₐ is a perfluoroalkyl, perfluoroether, or perfluoroaryl group, and R_{b} is a linking group, typically a C1-C6 aliphatic (linear, non-linear, branched, non-branched, saturated or non-saturated), aromatic, or a C1-C6 hydrocarbon group such as -CH₂CH₂CH₂-, where the fluorocarbon group is attached to the linking group and the linking group is attached to the nitrogen such that the nitrogen is not directly attached to the fluorocarbon Ra. In the case where the linking group R_{b} is C1-C6 aliphatic group, a C1-C6 hydrocarbon group, such as -CH₂CH₂CH₂-, is favored. In the case where the linking group R_{b} is aromatic, a C6 aromatic group is favored. Preferably, the quaternary ammonium salt contains two or three CO₂-philic groups, R¹R²R³R⁴. Additional CO₂-philic groups could be utilized such as silicone-based moieties and carbonyl-containing moieties such as acetate, ethyl carbonate.

Typically, and preferably, one or more of the groups attached to the nitrogen is not a CO₂-philic group. Of the non-CO₂-philic groups, R¹R²R³R⁴, typically one group is a C1-C6 aliphatic or C1-C6 hydrocarbon group such as a methyl, ethyl, propyl, butyl, or hexyl group.

The negatively charge ion, represented by the formula X-, is in some embodiments selected from a large group of negatively charged ions. The ion, X-, can be hydroxide, or any atom or group of atoms capable of supporting an extra valence electron. Prototypical examples include: halides, (F, C1, Br, I), oxides, carbonates, borates, cyanates, alkoxides, sulfides, phosphides, phosphates, tosylates, antimonates, arsenates, halogenates, cyanides, nitrates, nitrites, thiocyanates, sulfonates and other organic and inorganic anions. The anion may or may not contain fluorine or fluorinated substituents.

In one preferred embodiment of the ammonium complex R¹R²R³R⁴N⁺, R¹ is different from R², R³, and R⁴. This causes the cation to be asymmetric. For the ammonium complexes described in this invention, significant property differences for various combinations of cations and anions were observed. For ammonium complexes, low ion pair energy is favored by ions that are large and unsymmetrical (Copenhafer, et al.; J. Am. Chem. Soc.; 1951; 73(10); 4557-4561). Generally, we observed that increasing the size or the asymmetry or both of the component ions of our ammonium complex resulted in greater reactivity. With this understanding, we have determined that ammonium complexes of low ion pair energy are more effective in this invention than those with higher ion pair energies. Preferred ammonium complexes have an ion pair energy that is less than that of (R¹)₂Me₂N⁺⁻Cl⁻, where R¹ is C₃F₇CH₂CH₂CH₂-.

Ammonium hydroxide complexes are used in conventional aqueous based resist development. While CO₂-philic ammonium hydroxides have been prepared and found to be somewhat effective in the described CO₂ development process, in fact preferred ammonium complexes do not contain hydroxide anions. Ammonium hydroxides are generally unstable due to easy elimination of the amine through Hoffman elimination. The activity of ammonium hydroxide complexes is also low due to relatively high ion-pair energy. Finally, ammonium hydroxide complexes have poor solubility in CO₂ relative to ammonium complexes containing larger, softer or fluorinated anions.

Exemplary CO₂-philic groups may include a fluorine-containing segment or a siloxane-containing segment. The fluorine-containing segment is typically a fluorinated alkane (aliphatic) with between 1 and 20 carbon atoms, branched or non-branched. The fluorine-containing segment may also be aromatic or even polymeric in nature. As used herein, a "fluoropolymer" has its conventional meaning in the art and should also be understood to include low molecular weight oligomers, i.e., those which have a degree of polymerization greater than or equal to two. See, in general, Banks et al., Organofluorine Compounds: Principals and Applications (1994); see also Fluorine-Containing Polymers, Encyclopedia of Polymer Science and Engineering 256 (H. Mark et al. Eds. 2 d Ed. 1985).

Exemplary fluoropolymers are formed from monomers which may include fluoroacrylate monomers such as 2-(N-ethylperfluorooctanesulfonam- ido) ethyl acrylate ("EtFOSEA"), 2-(N-ethylperfluorooctanesulfonamido) ethyl methacrylate ("EtFOSEMA"), 2-(N-methylperfluorooctanesulfonamido) ethyl acrylate ("MeFOSEA"), 2-(N-methylperfluorooctanesulfonamido) ethyl methacrylate ("MeFOSEMA"), 1,1'-dihydroperfluorooctyl acrylate ("FOA"), 1,1'-dihydroperfluorooctyl methacrylate ("FOMA"), 1,1',2,2'-tetrahydroper-fluoroalkylacrylate, 1,1',2,2'-tetrahydro perfluoroalkylmethacrylate and other fluoromethacrylates; fluorostyrene monomers such as alpha-fluorostyrene and 2,4,6-trifluoromethylstyrene; fluoroalkylene oxide monomers such as hexafluoropropylene oxide and perfluorocyclohexane oxide; fluoroolefins such as tetrafluoroethylene, vinylidine fluoride, and chlorotrifluoroethylene; and fluorinated alkyl vinyl ether monomers such as perfluoro(propyl vinyl ether) and perfluoro(methyl vinyl ether). Copolymers using the above monomers may also be employed.

Exemplary siloxane-containing segments include alkyl, fluoroalkyl, and chloroalkyl siloxanes. More specifically, dimethyl siloxanes and polydimethylsiloxane materials are useful. Mixtures of any of the above may be used. See, e.g., U.S. Patents Nos. 5,866,005, 6,270,531, and 6,297,206.

In some cases, organic acetates, including highly-acetylated sugars, and ether-carbonate and polyether-carbonates may be used as CO₂-philic components.

The preferable content of the supercritical developer described above is;
(a) a quaternary ammonium salt as described above, typically from 0.1, 0.5 or 1.5 percent by mass to 10 or 20 percent by mass;
(b) carbon dioxide to balance, typically at least 40, 50 60, or 70 percent by mass;
(c) optionally, where desired, from 0, 0.01, 0.1, 0.5, 1 or 2 percent by mass to 5 or 10 percent by mass or more of surfactant (preferably a CO₂-philic surfactant);
(d) optionally, where desired, from 0, 0.01, 0.1, 1 or 2 percent by mass to 30, 40 or 50 percent by mass or more of an organic solvent; and
(e) optionally, and in some embodiments less preferably, from 0.01, or 0.1 percent by mass to 2, 5 or 10 percent by mass of water (and in other embodiments 0 percent water).

### Etching Step

Next, in general, the etching step is carried out using the resist pattern obtained as described above as a mask. In the etching step, the substrate and the like at the region not covered with the resist are selectively removed by etching through irradiating at least one of a plasma and/or reactive ion using the pattern as a mask.

The method for etching is not particularly limited. For example, a known method such as chemical or physical etching, e.g., chemical etching such as down flow etching or chemical dry etching; physical etching such as sputter etching or ion beam etching; RIE (reactive ion beam); or the like can be used.

Next, the present invention will be explained in more detail with reference to Examples; however, the present invention should not be construed as being limited thereto.

### Example 1

### (Preparation of Resist Composition for supercritical Development Process)

A resist composition was obtained by dissolving 100 parts by mass of the resin represented by the following general formula (XI), 8.0 parts by mass of a compound represented by the following general formula (XII) as an acid generator, 1.60 parts by mass of tri-n-octylamine, and 0.64 parts by mass of salicylic acid in propylene glycol monomethyl ether acetate so that the concentration of the solid content was 5.0% by mass. 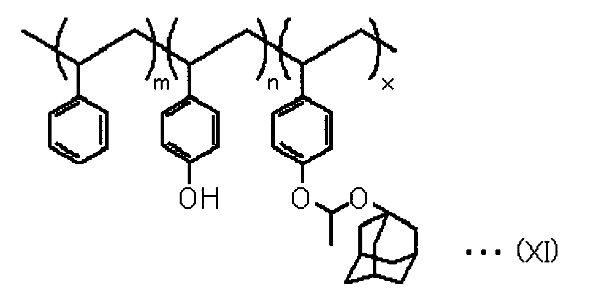 (m : n : x = 9.4 : 60.7 : 29.9)

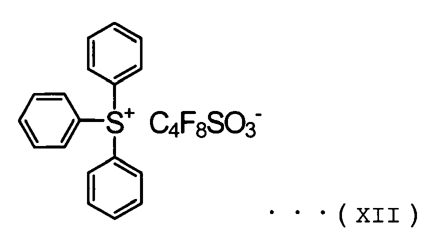

### (Coating of Resist Composition)

On a silicon wafer was coated the negative resist composition obtained as described above, using a spinner. After conducting a prebaking treatment at 100°C for 90 seconds, the coated resist film having a film thickness of 150 nm was obtained through drying.

### (Drawing)

Next, drawing of the pattern was carried out by irradiating an electron beam directly on the resulting coated resist film using an electron-beam drawing apparatus (manufactured by Hitachi Co., Ltd., trade name: HD-800, accelarating voltage 70 kV).

### (Development)

After the drawing, the substrate was subjected to a post-exposure baking (PEB) treatment at 100°C for 110 seconds. The substrate was then placed in a closed pressure-resistant vessel adjusted to 50°C, 500 mg of the quarternary ammonium hydroxide represented by the following general formula (XIII) was injected whereto, carbon dioxide was then charged into the vessel so that the pressure in the pressure-resistant vessel was 250 bars, and the supercritical development was carried out for 15 minutes.

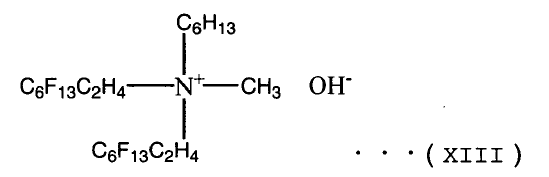

### (Rinsing)

The resist pattern was formed following water rinsing with pure water for 30 seconds.

When the resulting resist pattern was observed with an scanning electron microscope (SEM), excellent resolution was achieved in the horizontal width of the line of 80 nm and the vertical line and space (L & S) pattern wherein both LER and LWR were reduced. In addition, the cross-sectional shape of the resist pattern was rectangle and no pattern collapse was observed.

### Example 2

### (Preparation of Resist Composition for supercritical Development Process)

A resist composition was obtained by dissolving 100 parts by mass of the resin represented by the following general formula (XIV), 6.0 parts by mass of a compound represented by the aforementioned general formula (XII) as an acid generator, 0.50 parts by mass of tri-n-octylamine, and 0.20 parts by mass of salicylic acid in propylene glycol monomethyl ether acetate so that the concentration of the solid content was 7.0% by mass. 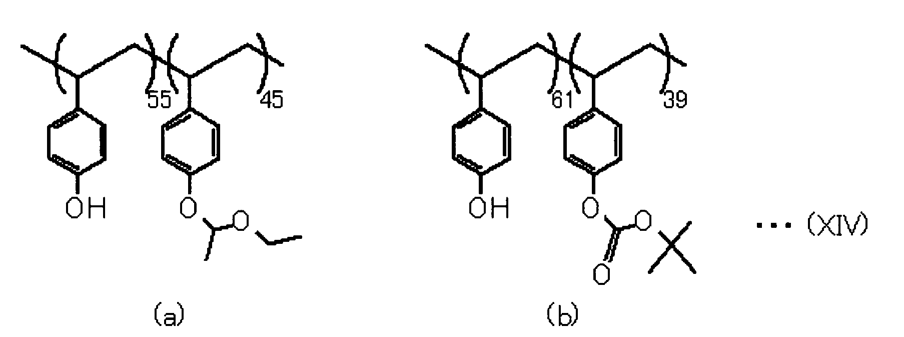 ((a) : (b) = 80 : 20 % by mass)

### [Coating of Resist Composition]

On a silicon wafer was coated the resist composition obtained as described above, using a spinner. After conducting a prebaking treatment at 110°C for 90 seconds, the coated film having a film thickness of 600 nm was obtained through drying.

### (Drawing)

Next, drawing of the resist pattern was carried out by irradiating an electron beam directly on the resulting coated film using an electron-beam drawing apparatus (manufactured by Hitachi Co., Ltd., trade name: HL-800, accelerating voltage 70 kV) .

### (Development)

After the irradiation, the substrate was subjected to a post-exposure baking (PEB) treatment at 110°C for 90 seconds. Then the development process using the supercritical developer was carried out in a similar manner to Example 1.

### (Rinsing)

The resist pattern was formed following water rinsing with pure water for 30 seconds.

When the resulting resist pattern was observed with an scanning electron microscope (SEM), excellent resolution was achieved in the horizontal width of the line of 80 nm and the vertical line and space (L & S) pattern wherein both LER and LWR were reduced. In addition, the cross-sectional shape of the resist pattern was rectangle and no pattern collapse was observed.

While preferred embodiments of the present invention have been described and illustrated above, it is to be understood that they are exemplary of the invention and are not to be considered to be limiting. Additions, omissions, substitutions, and other modifications can be made thereto without departing from the spirit or scope of the present invention. Accordingly, the invention is not to be considered to be limited by the foregoing description and is only limited by the scope of the appended claims.

## Claims

1. resist composition for supercritical development process for forming a resist pattern wherein exposed resist film was treated with a supercritical developer comprising a supercritical fluid to allow the unexposed region of said exposed resist film to be selectively removed, said composition comprises:
a base material resin which is not removed by said supercritical developer in the presence of acid (A); and
an acid generator which generates an acid upon activation with at least one of lights and electromagnetic waves (B).

2. The composition according to claim 1 wherein said supercritical fluid comprises carbon dioxide and quarternary ammonium salts.

3. The composition according to claim 1 or 2 wherein:
said base resin (A) includes a polymer having a constituent unit (a1) represented by the following general formula (I); and
at least a part of hydrogen atoms of the hydroxyl groups of said constituent unit (a1) are substituted by at least one of an acid-dissociable group represented by the following general formula (II) and the following general formula (III). 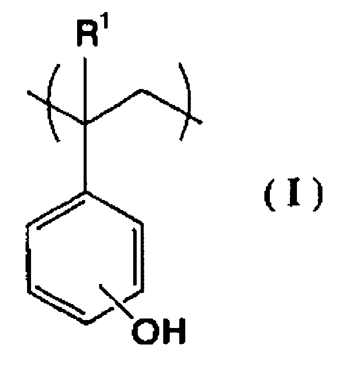 Wherein
R¹ represents a hydrogen atom or a methyl group. 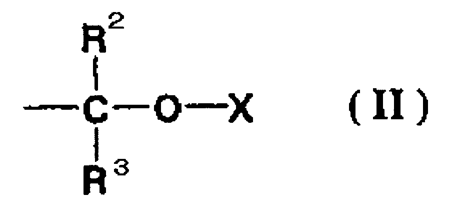
wherein
R² and R³ each independently represent an alkyl group having 1 to 5 carbon atoms or a hydrogen atom, and
X represents any one of the groups selected from the group consisting of an alkyl group having 1 to 5 carbon atoms, an aliphatic polycyclic group, and an aromatic polycyclic hydrocarbon group. 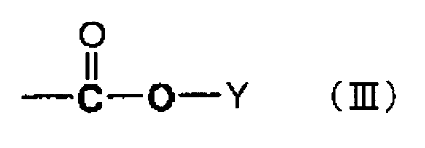
wherein
Y represents any one of the groups selected from
the group consisting of an alkyl group having 1 to 5 carbon atoms, an aliphatic polycyclic group, and an aromatic polycyclic hydrocarbon group

4. The composition according to any one of claims 1 to 3 wherein said polymer included in said base resin (A) further comprises a constituent unit (a2) represented by the following general formula (IV) 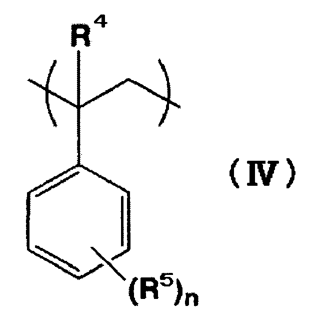 wherein
R⁴ represents a hydrogen atom or a methyl group,
R⁵ represents an alkyl group having 1 to 5 carbon atoms, and
n represents an integer of 0 or 1 to 3.

5. The composition according to any one of claims 1 to 4 wherein one of at least said X and Y are adamantyl group or naphthyl group.

6. The composition according to any one of claims 1 to 5 wherein the content of said acid generator (B) is from 5 parts by mass to 30 parts by mass per 100 parts by mass of said base resin (A).

7. The composition according to any one of claims 1 to 6 which further comprises a basic compound (C).

8. The composition according to any one of claims 1 to 7 wherein the content of said basic compound (C) is from 0.1 part by mass to 20 parts by mass per 100 parts by mass of said base resin (A).

9. The composition according to any one of claims 1 to 8 wherein said basic compound (C) is secondary or tertiary amine having alkyl groups having 7 to 15 carbon atoms.

10. The composition according to any one of claims 1 to 9 which further comprises an organic acid (D) in an amount of 0.1 part by mass to 20 parts by mass per 100 parts by mass of said base resin (A).
